# FASCICULE DE BREVET EUROPEEN

(11) **EP 1 114 067 B1**
(45) Date de publication et mention de la délivrance du brevet: **23.10.2002**
(21) Numéro de dépôt: 99936669.3
(22) Date de dépôt: 02.08.1999
(51) Int. Cl.: C08F 2/50, G03F 7/029

(54) **PROCEDE DE POLYMERISATION ET/OU DE RETICULATION SOUS FAISCEAU D'ELECTRONS ET/OU RAYONS GAMMA**
POLYMERISATIONS- UND/ODER VERNETZUNGSVERFAHREN DURCH ELEKTRONENSTRAHLEN UND/ODER GAMMA-STRAHLUNG
POLYMERISATION AND/OR CROSSLINKING METHOD UNDER ELECTRON BEAM AND/OR GAMMA RADIATION

(30) Priorité: 11.08.1998 FR 9810297; 11.06.1999 FR 9907421
(43) Date de publication de la demande: 11.07.2001
(73) Titulaire: RHODIA CHIMIE, 92408 Courbevoie Cédex (FR)
(72) Inventeur: PRIOU, Christian, West Windsor, NJ 08550 (US); FRANCES, Jean-Marc, 69330 Meyzieu (FR); DHALER, Didier, 69160 Tassin (FR)
(86) Numéro de dépôt international: FR9901911
(87) Numéro de publication internationale: WO00009572

(56) Documents cités:
- EP-A- 0 353 030
- DE-A- 1 815 868
- BORDEN D. G.: "REVIEW OF LIGHT-SENSITIVE TETRAARYLBORATES" PHOTOGRAPHIC SCIENCE AND ENGINEERING, vol. 16, no. 4, juillet 1992 (1992-07) - août 1992 (1992-08), pages 300-312, XP002041791

## Description

Le domaine de l'invention est celui de l'amorçage des réactions de polymérisation(s) et/ou de réticulation(s) de monomères, oligomères et/ou polymères, comprenant des radicaux fonctionnels réactifs aptes à former des pontages intra et inter caténaires, de manière à obtenir un revêtement ou un matériau composite polymérisé et/ou réticulé ayant une certaine dureté et une certaine tenue mécanique.

Plus précisément, la présente invention a pour objet un nouveau procédé de polymérisation et/ou réticulation en présence de nouveaux amorceurs activables sous faisceau d'électrons et/ou rayons gamma comprenant au moins un dérivé du bore permettant l'initiation et le déroulement de réactions de formations de polymères et/ou de résines, à partir de substrats formés de monomères, oligomères et/ou de polymères à groupements organofonctionnels réactifs.

Les réactions plus particulièrement concernées sont celles dans lesquelles des agents agissent comme promoteurs directs des liaisons inter et/ou intra caténaires. Dans le cas présent, ces réactions sont initiées sous activation par faisceau d'électrons ou par rayonnement gamma.

Dans la présente description, les polymères et/ou résines obtenus sont préparés à partir de monomères, oligomères et/ou polymères qui sont soit (1) de nature organique, notamment uniquement hydrocarbonée, soit (2) de nature polyorganosiloxane, et comprennent dans leur structure des groupements organofonctionnels, par exemple du type époxyde, oxétannes, et/ou alkényl-éther, qui réagissent après activation par faisceau d'électrons et/ou rayons gamma des amorceurs selon l'invention décrite ci-après. On peut également en plus utiliser (3) des monomères, oligomères et/ou polymères avec des groupements acryliques et/ou des groupements méthacryliques, qui peuvent être ajoutés dans le milieu de polymérisation contenant des espèces (1) et/ou (2).

La présente invention a également pour objet des compositions comprenant les matériaux de base (monomères, oligomères et/ou polymères) polymérisables et/ou réticulables, de préférence de nature polyorganosiloxanique, les amorceurs décrits ci-après, et éventuellement un ou plusieurs additifs choisis parmi ceux généralement connus dans les applications auxquelles sont destinées ces compositions.

Par exemple, ces compositions peuvent être utilisées pour la réalisation de revêtements sur objets tels que des articles ou des supports solides, notamment support papier, tissu, film polymère de type polyester ou polyoléfine, support aluminium, et/ou support fer blanc.

Des amorceurs de polymérisation et/ou réticulation des monomères, oligomères et/ou polymères comprenant dans leur structure des groupements organofonctionnels réactifs sont décrits dans EP-0 562 897. Les sels amorceurs de ce brevet représentent un progrès technique notable par rapport aux amorceurs antérieurement connus de type sels d'onium ou de complexes organométalliques, et en particulier par rapport à ceux dont l'anion du sel amorceur est SbF₆⁻ qui est l'un des seuls qui soit correct sur le plan des performances, mais qui pose de graves problèmes d'utilisation en raison de la présence de métaux lourds.

Pour apprécier les performances d'amorceurs activables sous faisceau d'électrons et/ou rayons gamma, on évalue leur aptitude à polymériser un polymère ou matrice par l'intermédiaire de tests tels que celui du toucher ou encore des tests métier tels que celui de la force de pelage pour les revêtements anti-adhérents.

L'un des objectifs essentiels de la présente invention est la mise au point d'un nouveau procédé permettant la polymérisation et/ou réticulation de matrice à base de monomères, oligomères et/ou polymères en présence de nouveaux amorceurs activables par faisceau d'électrons et/ou rayons gamma.

Il est à noter que les amorceurs de ce nouveau procédé ont une réactivité nettement améliorée notamment par rapport à ceux contenant au sein de leur structure un cation iodonium et/ou anion dérivé d'antimoine. En outre, l'utilisation de ces nouveaux amorceurs ne nécessite pas obligatoirement des conditions d'atmosphère inerte et, de plus ils se révèlent beaucoup moins toxiques.

Un objectif essentiel de l'invention est de fournir un procédé performant vis-à-vis du plus grand nombre de monomères, oligomères et/ou polymères organofonctionnels polymérisables et/ou réticulables sous activation de faisceau d'électrons et/ou rayons gamma ; les monomères, oligomères et/ou polymères étant notamment (1) de nature organique, de préférence uniquement hydrocarbonée, ou (2) de nature polyorganosiloxane, éventuellement en mélange (3) avec d'autres monomères, oligomères et/ou polymères contenant des groupes acryliques et/ou méthacryliques.

Un autre objectif essentiel de l'invention est de fournir un procédé utilisant des amorceurs efficaces, en faible concentration et ne nécessitant que de faibles quantités d'énergie (exprimée en kilogray) pour effectuer la polymérisation et/ou réticulation. De ce fait, les procédés industriels utilisant ces types d'amorceurs se révèlent particulièrement économiques.

Un autre objectif essentiel de l'invention est de fournir un procédé de haute performance dans lequel les réactions de polymérisation et/ou réticulation s'effectuent à des vitesses élevées. Ainsi, la durée d'activation sous faisceau d'électrons et/ou rayons gamma est très courte et est généralement d'environ moins d'une seconde et de l'ordre de quelques centièmes de seconde pour la réalisation de revêtements de très faible épaisseur. Bien entendu, le temps de polymérisation/réticulation est variable selon le nombre de sources de faisceau d'électrons et/ou rayons gamma, la durée de l'activation et la distance entre la composition et le(s) faisceaux activateurs. Ainsi, le procédé selon l'invention peut être mis en oeuvre avec des dispositifs industriels dans lesquels la vitesse de défilement de la composition à réticuler sur bande support est très élevée.

Un autre objectif de l'invention est de fournir des compositions de monomères, oligomères et/ou polymères organofonctionnels réticulables par l'intermédiaire des amorceurs activables par faisceau d'électrons et/ou rayons gamma. Les performances optimums sont notamment obtenues avec des compositions de monomères, oligomères et/ou polymères organofonctionnels de nature polyorganosiloxane.

Un autre objectif de l'invention est de fournir des compositions de ce type utilisables aussi bien en couche mince, dont l'épaisseur se situe par exemple dans l'intervalle allant de 0,1 à 10 µm, qu'en couche plus épaisse, dont l'épaisseur se situe par exemple dans l'intervalle allant d'une valeur supérieure à 10 micromètres à plusieurs centimètres.

Un autre objectif de l'invention est de fournir des compositions de ce type pour la préparation de matériaux composites.

Ces divers objectifs sont atteints par l'invention qui concerne tout d'abord, dans son premier objet, un nouveau procédé de réticulation et/ou polymérisation sous faisceau d'électrons et/ou rayons gamma, de compositions à base de monomères, oligomères et/ou de polymères à groupements organofonctionnels dans lequel la réticulation et/ou polymérisation s'effectue en présence d'un amorceur activable par faisceau d'électrons et/ou rayons gamma, comprenant un dérivé du bore de formule M⁺ B(Ar)₄⁻. **(I)** où :
- M⁺, entité portant une charge positive, est choisie parmi un métal alcalin des colonnes IA et IIA de la classification périodique (CAS version),
- Ar est un dérivé aromatique, éventuellement substitué par au moins un substituant choisi parmi un radical fluor, un radical chlore, une chaîne alkyle linéaire ou ramifiée, elle-même pouvant être substituée par au moins un groupement électroattracteur tel que CₙF₂ₙ₊₁ avec n étant compris entre 1 et 18 (par exemple:CF₃, C₃F₇,C₂F₅,C₈F₁₇) F, et OCF₃.

Selon une variante de l'invention, M est choisie parmi le lithium, le sodium, le césium et/ou le potassium.

A titre d'exemple, le dérivé du bore de l'amorceur selon l'invention est de formule : LiB(C₆F₅)₄, KB(C₆F₅)₄, KB(C₆H₃(CF₃)₂)₄ et CsB(C₆F₅)₄.

Les amorceurs selon l'invention peuvent être mis en oeuvre, tels qu'ils sont obtenus à l'issue de leur procédé de préparation, par exemple sous forme solide ou liquide, ou en solution dans au moins un solvant approprié, dans des compositions de monomères, oligomères et/ou polymères qui sont destinées à être polymérisées et/ou réticulées. Dans le cadre de l'invention, le terme solvant englobe les produits solubilisant les amorceurs solides et les produits diluant les amorceurs liquides ou solides.

De préférence, les amorceurs sont généralement mis en oeuvre en solution dans un solvant. Les proportions pondérales entre le ou les amorceurs, d'une part, et le solvant, d'autre part, sont comprises entre 0.1 et 99 parties pour 100 parties de solvant et, de préférence de 10 à 50 parties.

La solution est ensuite utilisée pour préparer un bain avec le ou les monomères, oligomères et/ou polymères à groupements fonctionnels réticulables, telle que ia concentration de l'amorceur ou des amorceurs présents soit comprise entre 0.01 et 5% en poids dans ledit bain, et de préférence entre 0.05 et 0.5%.

Les solvants utilisables pour les amorceurs sont très nombreux et variés et sont choisis selon l'amorceur utilisé et les autres constituants de la composition de l'invention. En général, les solvants peuvent être des alcools, des esters, des éthers, des cétones, et/ou des silicones.
Les silicones utilisées pour diluer et/ou solubiliser les amorceurs peuvent être similaires ou identiques aux monomères, oligomères et/ou polymères constituant la composition réticulable et/ou polymérisable.
Les alcools couramment employés sont le para-tolyl-éthanol, l'isopropyl-benzyl-alcool, l'alcool benzylique, le méthanol, l'éthanol, le propanol, l'isopropanol et le butanol. Les éthers communément usités sont le méthoxy-2-éthanol, l'éthoxy-2-éthanol, le diéthylène-glycol. Les esters usuels sont le dibutylmaléate, diméthyl-éthylmalonate, salycilate de méthyle, dioctyladipate, tartrate de butyle, lactate d'éthyle, lactate de n-butyle, lactate d'isopropyle. D'autres solvants utilisables pour le bain de l'amorceur et entrant dans les autres catégories de solvants citées ci-dessus sont l'acétonitrile, le benzonitrile, l'acétone, le cyclohexanone, et le tétrahydrofurane.

En outre, parmi les solvants utilisables pour mettre en solution le ou les amorceurs, certains types de solvants organiques donneurs de protons ainsi que certains types d'esters d'acides carboxyliques hydroxylés ont pour propriétés également d'améliorer significativement leurs performances de réactivité et de cinétique.
Parmi ces types de solvants, appelés diluants réactifs, on citera :
(1) l'alcool benzylique de formule générale suivante **(II)** : 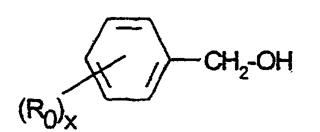 dans laquelle :
   - les groupements R₀ sont identiques ou différents et représentent un groupement électrodonneur ou électroaccepteur choisi parmi les alkyles linéaires ou ramifiés contenant 1 à 12 atomes de carbone, les alcoxyles linéaires ou ramifiés contenant 1 à 12 atomes de carbone, les cycloalkyles, les cycloalcoxyles, les aryles éventuellement substitués, de préférence par des halogènes ou des radicaux tels que par exemple NO₂,
   - x est entier compris entre 0 et 5.
(2) les esters d'acides carboxyliques hydroxylés, liquides à température ambiante (23°C), de formule générale: 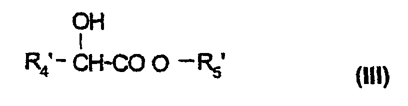 dans laquelle :
   - les symboles R₄' et R₅' sont identiques ou différents et représentent :
      · un radical alkyle, linéaire ou ramifié en C₁-C₁₀, éventuellement substitué par un groupe alkoxy linéaire ou ramifié en C₁-C₄,
      · un radical cycloalkyle en C₄-C₁₀, éventuellement substitué par un ou plusieurs groupe(s) alkyle(s) ou alkoxy linéaire(s) ou ramifié(s) en C₁-C₄,
      · un radical aryle en C₅-C₁₂, éventuellement substitué par un ou plusieurs groupe(s) alkyle(s) ou alkoxy linéaire(s) ou ramifié(s) en C₁-C₄, et/ou
      · un radical aralkyle ou aroxyalkyle où la partie aryle est un groupe en C₅-C₁₂ éventuellement substitué par un ou plusieurs groupe(s) alkyle(s) ou alkoxy linéaire(s) ou ramifié(s) en C₁-C₄, et la partie alkyle est un groupe linéaire ou ramifié en C₁-C₄,
   - le symbole R₄' pouvant en outre représenter:
      · un radical alkoxy linéaire ou ramifié en C₁-C₁₅, et/ou
      · un radical cycloalkyloxy en C₄-C₁₀, éventuellement substitué par un ou plusieurs groupe(s) alkyle(s) ou alkoxy linéaire(s) ou ramifié(s) en C₁-C₄.

Selon une première autre disposition intéressante de l'invention prise dans son premier objet, la composition polymérisable et/ou réticulable est à base de monomère(s) et/ou oligomère(s) et/ou polymère(s), de nature polyorganosiloxane et/ou de nature organique, notamment hydrocarbonée.

Selon une deuxième autre disposition intéressante de l'invention prise dans son premier objet, la composition polymérisable et/ou réticulable est à base de monomère(s) et/ou oligomère(s) et/ou polymère(s), de nature polyorganosiloxane et/ou de nature organique, notamment hydrocarbonée, et comprend en outre des monomères, oligomères et/ou polymères à groupements organofonctionnels d'espèce acrylate; et notamment acrylates époxydés, acrylo-glycéro-polyester, acrylates multifonctionnels, acrylo-uréthanes, acrylo-polyéthers, acrylo-polyesters, polyesters insaturés, acrylo-acryliques.
Ces espèces acryliques, éventuellement en mélange, utilisables avec des monomère(s) et/ou oligomère(s) et/ou polymère(s) de nature polyorganosiloxane et/ou de nature organique, sont choisies de préférence parmi les espèces suivantes : triacrylate de triméthylolpropane, diacrylate de tripropylèneglycol, glycidylpropyl triacrylate, pentaérythritol triacrylate, dipentaérythritolpentaacrylate, pentaérythritoltetraacrylateéthoxylé, triméthylolpropane éthoxylatetriacrylate, Bisphénol-A éthoxylate diacrylate, tripropylèneglycol diacrylate, triéthylèneglycol diacrylate, tetraéthylèneglycoldiacrylate, polyethers acrylates, polyesters acrylates (par exemple le produit Ebecryl 810 de la société UCB-Radcure), et époxy acrylates (par exemple le produit Ebecryl 600 de la société UCB-Radcure).

Selon un autre des aspects de la présente invention, celle-ci concerne dans son second objet, des compositions comprenant au moins une matrice à base de monomère(s), d'oligomère(s) et/ou de polymère(s) de nature polyorganosiloxanique à groupements organofonctionnels polymérisables et/ou réticulables, et une quantité efficace d'au moins un amorceur du type de ceux conformes à l'invention et décrits ci-avant, éventuellement un accélérateur de polymérisation et/ou réticulation, et éventuellement encore un ou plusieurs additifs choisis parmi ceux généralement connus dans les applications auxquelles sont destinées ces compositions.

Par quantité efficace d'amorceur, on entend selon l'invention la quantité suffisante pour amorcer la polymérisation et/ou la réticulation. Cette quantité est généralement comprise entre 0,01 et 1 parties en poids, le plus souvent entre 0,05 et 0,5 parties en poids pour polymériser et/ou réticuler 100 parties en poids de la matrice.

Selon une troisième disposition intéressante de l'invention prise dans son premier objet et une première disposition intéressante de l'invention prise dans son second objet, le(s) monomère(s) et/ou oligomère(s) et/ou polymère(s) sont de nature polyorganosiloxane, constitués de motifs de formule **(IV)** et terminés par des motifs de formule **(V)** ou cycliques constitués de motifs de formule **(IV)** représentées ci-dessous : 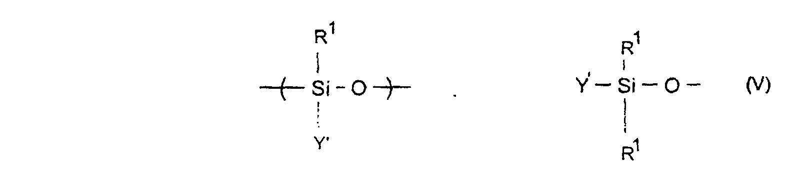 dans lesquelles :
- les symboles **R**^{**1**} sont semblables ou différents et représentent :
   - un radical alkyle linéaire ou ramifié contenant 1 à 8 atomes de carbone, éventuellement substitué par au moins un halogène, de préférence le fluor, les radicaux alkyle étant de préférence méthyle, éthyle, propyle, octyle et 3,3,3-trifluoropropyle,
   - un radical cycloalkyle contenant entre 5 et 8 atomes de carbone cycliques, éventuellement substitué,
   - un radical aryle contenant entre 6 et 12 atomes de carbone pouvant être substitué, de préférence phényle ou dichlorophényle,
   - une partie aralkyle ayant une partie alkyle contenant entre 5 et 14 atomes de carbone et une partie aryle contenant entre 6 et 12 atomes de carbone, substituée éventuellement sur la partie aryle par des halogènes, des alkyles et/ou des alkoxyles contenant 1 à 3 atomes de carbone,
- les symboles **Y'** sont semblables ou différents et représentent :
   - le groupement **R**^{**1**}**,**
   - un radical hydrogène,
   - et/ou un groupement organofonctionnel réticulable, de préférence un groupement époxyfonctionnel et/ou vinyloxyfonctionnel, relié au silicium du polyorganosiloxane par l'intermédiaire d'un radical divalent contenant de 2 à 20 atomes de carbone et pouvant contenir au moins un hétéroatome, de préférence de l'oxygène,
   - et l'un au moins des symboles **Y'** représentant un groupement organique fonctionnel réticulable.

De préférence, au moins un des symboles **R**^{**1**} des polyorganosiloxanes utilisés représente un radical phényle, tolyle ou dichlorophényle.

Selon une variante avantageuse de l'invention, les polyorganosiloxanes utilisés comportent de 1 à 10 groupements organofonctionnels par chaîne macromoléculaire. Pour un groupement époxyfonctionnel cela correspond à des taux d'époxyde variant de 20 à 2000 meq. molaire/100 g de polyorganosiloxane.

Les polyorganosiloxanes linéaires peuvent être des huiles de viscosité dynamique à 25°C, de l'ordre de 10 à 10 000 mPa.s à 25°C, généralement de l'ordre de 50 à 5 000 mPa.s à 25°C et, plus préférentiellement encore, de 100 à 600 mPa.s à 25°C, ou des gommes présentant une masse moléculaire de l'ordre de 1 000 000.

Lorsqu'il s'agit de polyorganosiloxanes cycliques, ceux-ci sont constitués de motifs (**IV**) qui peuvent être, par exemple, du type dialkylsiloxy ou alkylarylsiloxy. Ces polyorganosiloxanes cycliques présentent une viscosité de l'ordre de 1 à 5 000 mPa.s.

Comme exemples de radicaux divalents reliant un groupement organofonctionnel du type époxy, on peut citer ceux inclus dans les formules suivantes :

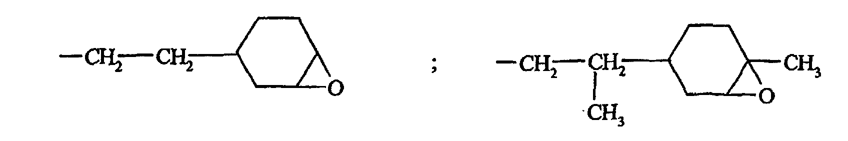

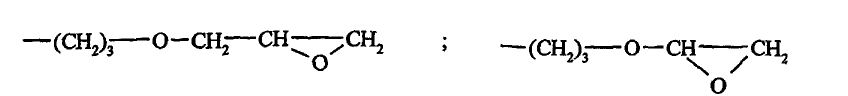

S'agissant des groupements organofonctionnels du type alkényléther, on peut mentionner ceux contenus dans les formules suivantes :

-(CH₂)₃-O-CH=CH₂ ,

-(CH₂)₃-O-R²-O-CH=CH₂ ,

-(CH₂)₃-O-CH=CH-R³ ,

dans lesquelles :
- **R**^{**2**} représente :
   - un radical alkylène linéaire ou ramifié en C₁-C₁₂, éventuellement substitué,
   - ou un radical arylène en C₅-C₁₂, de préférence phénylène, éventuellement substitué, de préférence par un à trois groupements alkyles en C₁-C₆,
- **R**^{**3**} représente un radical alkyle linéaire ou ramifié en C₁-C₆.

La viscosité dynamique à 25°C, de toutes les silicones considérées dans la présente description peut être mesurée à l'aide d'un viscosimètre BROOKFIELD, selon la norme AFNOR NFT 76 102 de février 1972.

Selon une deuxième autre disposition intéressante de l'invention prise dans son second objet, la matrice de la composition polymérisable et/ou réticulable est à base de monomère(s) et/ou oligomère(s) et/ou polymère(s), de nature polyorganosiloxane et de nature organique, notamment hydrocarbonée.

Selon une troisième autre disposition intéressante de l'invention prise dans son second objet, la matrice de la composition polymérisable et/ou réticulable est à base de monomère(s) et/ou oligomère(s) et/ou polymère(s), de nature polyorganosiloxane et éventuellement de nature organique, notamment hydrocarbonée, et comprend en outre des monomères, oligomères et/ou polymères à groupements organofonctionnels d'espèce acrylate ; et notamment acrylates époxydés, acrylo-glycéro-polyester, acrylates multifonctionnels, acrylo-uréthanes, acrylo-polyéthers, acrylo-polyesters, polyesters insaturés, acrylo-acryliques.
Ces espèces acryliques, éventuellement en mélange, utilisables avec des monomère(s) et/ou oligomère(s) et/ou polymère(s) de nature polyorganosiloxane et/ou de nature organique, sont choisies de préférence parmi les espèces suivantes : triacrylate de triméthylolpropane, diacrylate de tripropylèneglycol, glycidylpropyltriacrylate, pentaérythritol triacrylate, dipentaerythritol pentaacrylate, pentaerythritoltetraacrylateéthoxylé , triméthylolpropane éthoxylatetriacrylate, Bisphénol-A éthoxylate diacrylate, tripropylèneglycol diacrylate, triéthylèneglycol diacrylate, tetraéthylèneglycoldiacrylate, polyethers acrylates, polyesters acrylates (par exemple le produit Ebecryl 810 de la société UCB-Radcure), et époxy acrylates (par exemple le produit Ebecryl 600 de la société UCB-Radcure).

Il est rappelé que, dans la présente description, l'expression "acrylique" englobe des composés comprenant la fonction de type CH₂=CH-COO- ou de type CH₂=C(CH₃)-COO-.

Classiquement les compositions selon l'invention peuvent comprendre, en outre, un ou plusieurs additifs choisis en fonction de l'application finale visée.

Quand la composition polymérisable et/ou réticulable est à base d'au moins une espèce organique, en mélange éventuellement avec des monomères, oligomères et/ou polymères de nature acrylique, les additifs peuvent être notamment des composés éventuellement sous forme de polymères, à hydrogènes mobiles comme des alcools, des glycols et des polyols, utiles pour améliorer la flexibilité du matériau durci après polymérisation et/ou réticulation ; on peut citer par exemple les polycaprolactones-polyols, en particulier le polymère obtenu au départ de 2-éthyl-2-(hydroxyméthyl)-1,3-propane-diol et de 2-oxépanone tel que le produit TONE POLYOL-301 commercialisé par la Société UNION CARBIDE, ou les autres polymères commerciaux TONE POLYOL 201 et TONE POLYOL 12703 de la société UNION CARBIDE. En outre, dans ce cas, on peut citer comme additifs, les diacides à longue chaîne alkyle, les esters gras d'acides insaturés époxydés ou non, par exemple l'huile de soja époxydée ou l'huile de lin époxydée, le 2-éthylhexylester époxydé, le 2-éthylhexyl époxy stéarate, l'époxystéarate d'octyle, les esters acryliques époxydés, les acrylates d'huile de soja époxydés, les acrylates d'huile de lin époxydés, l'éther diglycidique de glycolpolypropylène, les époxydes aliphatiques à longue chaîne.

Il peut s'agir encore, quelle que soit la nature de la matrice polymérisable, par exemple : de charges telles que notamment des fibres synthétiques (polymères) ou naturelles broyées, du carbonate de calcium, du talc, de l'argile, du dioxyde de titane, de la silice de précipitation ou de combustion ; de colorants solubles ; d'inhibiteurs d'oxydation et de corrosion ; de modulateurs d'adhérence organosiliciques ou non ; d'agents fongicides, bactéricides, anti-microbiens; et/ou de tout autre matériau n'interférant pas avec l'activité de l'amorceur.

Pour la mise en oeuvre des amorceurs selon l'invention, différentes sources d'irradiation par bombardement électronique peuvent être utilisées pour effectuer la polymérisation et/ou réticulation des monomères, oligomères et/ou polymères. Il est à noter que les mécanismes de réactions mises en jeu sont de différents types ; l'un des type identifiés faisant intervenir des espèces cationiques.

A titre d'exemples d'appareils utilisables, on citera ceux de type à faisceau d'électrons pulsé (Scanned Electron Beam Accelerator) et ceux de type à faisceau d'électrons en rideau (Electron Curtain Accelerator). Dans les exemples et tests qui suivent, est utilisé un appareil à faisceau d'électrons pulsé. A titre d'alternative, on peut utiliser pour la polymérisation et/ou réticulation comme source d'irradiation des rayons gamma.

Les résines obtenues à partir du procédé ou de composition selon l'invention sont utilisables pour la fabrication de revêtement et/ou de matériaux composites. A titre d'exemples non limitatifs, le revêtement préparé peut être un vernis, un revêtement adhésif, un revêtement anti-adhérent et/ou une encre.

### Exemples et tests

Les 2 séries de préparations et tests **A** et **B** suivants permettront notamment de mieux comprendre l'invention et de faire ressortir tous ses avantages et entrevoir quelques-unes de ses variantes de réalisation. Elles démontrent notamment la réactivité améliorée sous faisceau d'électrons des amorceurs selon l'invention par rapport à ceux de l'art antérieur, notamment ceux à base de sels d'iodonium.

Les amorceurs testés se trouvent dans le tableau **I** ci-dessous. Ces amorceurs ont été évalués sous faisceau d'électrons en présence de la silicone époxy . Le silicone epoxy est un (1,2-époxy-4-éthyl-cyclohexyl)-polydiméthylsiloxane de formule **(VI)** dans laquelle a et b ont respectivement pour valeurs moyennes 7 et 83.

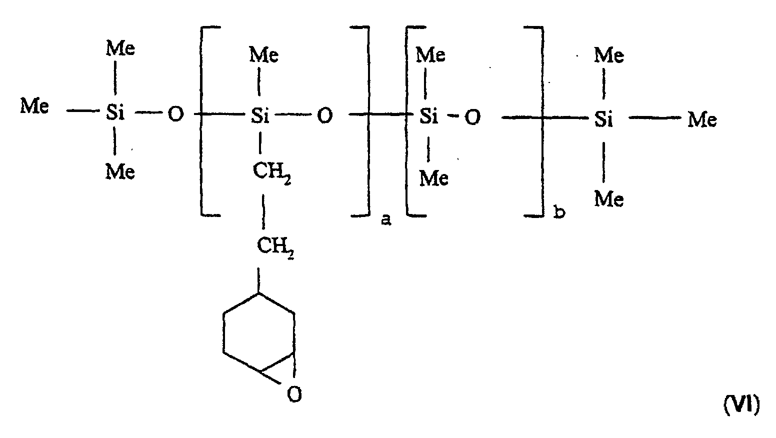

Les amorceurs testés sont répertoriés ci-dessous au tableau I.

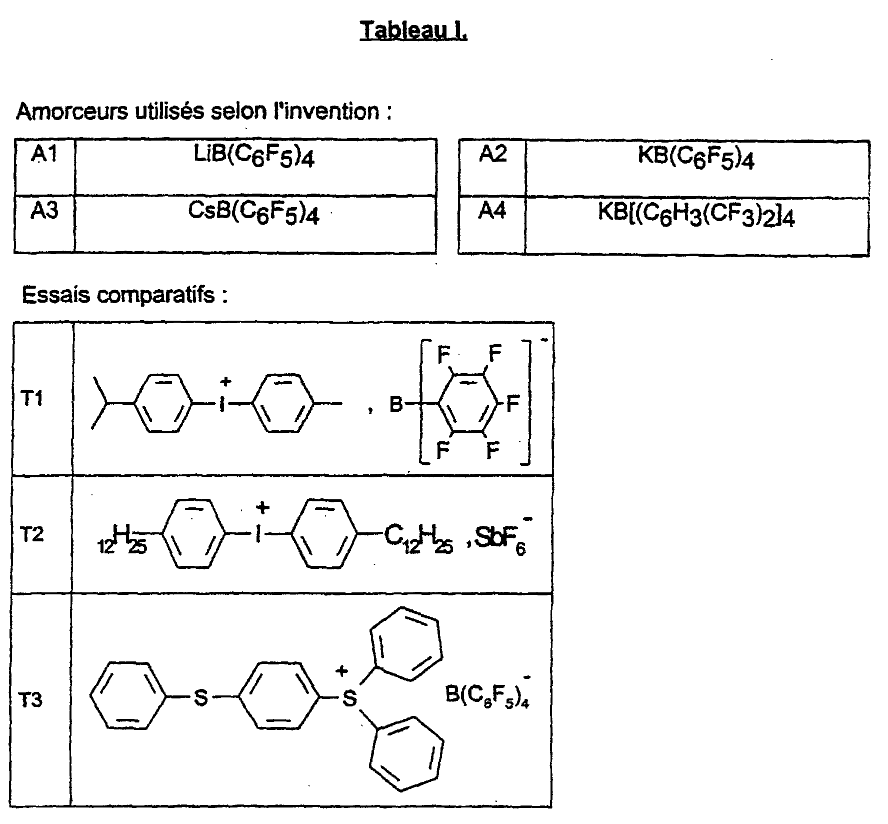

### A1 - Préparation des formulations à enduire.

On mélange l'amorceur avec le solvant approprié. Puis, cette solution est ajoutée à la matrice silicone époxy (VI). Les mélanges amorceur-solvant et les formulations avec le silicone époxy (VI) sont donnés ci-dessous respectivement dans le tableau 2 et le tableau 3.

Les compositions C1, C2, C3, C5, et C8 contiennent la même concentration molaire en amorceur, à savoir 0,197 x 10⁻³ mole/100 g de silicone époxy.

La composition C6 est deux fois plus riche en amorceur, en raison de la plus faible réactivité de ce sel d'iodonium, soit 0,586 x 10⁻³ mole/100 g de résine silicone.

La composition C7 contient deux fois moins d'amorceur que les autres compositions, à savoir 0,097 x 10⁻³ mole/100 g de silicone époxy, de façon à exemplifier la très grande réactivité des sels de l'invention.

**Tableau 2.**

| Amorceur | Solvant | % poids de l'amorceur dans Solvant |
|---|---|---|
| A1 | Isopropanol | 16,9 |
| A2 | Isopropanol | 17,7 |
| T1 | Isopropanol | 25 |
| T2 | Dodécylbenzène + mélange d'alkylglycidyléthers | 50 |
| T3 | Lactate de butyle | 25,9 |
| A4 | Isopropanol | 10,6 |
| A3 | Acétone | 20 |

L'amorceur T2 présentant une très faible solubilité intrinsèque dans les systèmes à base d'époxysilicone, seule la formulation indiquée dans le tableau 2 a conduit à des revêtements réticulés.

Les autres amorceurs du tableau 2 sont compatibles avec de nombreux solvants usuels et donc permettent la mise au point de nombreuses et différentes formulations.

**Tableau 3**

| **Composition** | **Amorceur** | **Masse solution amorceur (g)** | **Masse de Silicone époxy (g)** | **Concentration en Amorceur dans composition** (% pds) |
|---|---|---|---|---|
| C1 | A1 | 0,935 | 100 | 0,13 |
| C2 | A2 | 0,941 | 100 | 0,14 |
| C3 | T1 | 1,00 | 100 | 0,2 |
| C4 | T1 | 0,5 | 100 | 0,1 |
| C5 | T3 | 1,01 | 100 | 0,21 |
| C6 | T2 | 1 | 100 | 0,5 |
| C7 | A4 | 0,887 | 100 | 0,085 |
| C8 | A3 | 0,96 | 100 | 0,16 |

Toutes les compositions sont limpides, à l'exception de la formulation C5 qui présente un léger trouble. Après 22 heures à température ambiante, la viscosité des compositions C1,C2, C7 et C8 n'a pas évolué, ce qui montre l'excellente stabilité thermique des amorceurs revendiqués.

### A2 - Enduction.

Chacune des compositions est enduite à l'aide d'une barre de Meyer sur un support polyester 6001 non traité (36 microns d'épaisseur). L'épaisseur déposée est de l'ordre de 2 microns.

### A3 - Traitement du film enduit sous faisceau d'électrons.

Le traitement du film est effectué sous faisceau d'électrons à 175 KV avec un appareil à bombardement électronique Curtain CB150 commercialisé par la société ENERGY SCIENCE. Les traitements aux doses comprises entre 5 et 50 kGray sont réalisés à intensité constante I = 3 mA. Au-delà de ces valeurs, l'intensité est adaptée pour atteindre la dose voulue.

### A4 - Evaluation de la réticulation par le test au toucher.

Dans ces tests, on recherche la dose minimum nécessaire (unité : kiloGray), c'est-à-dire l'énergie minimum nécessaire, pour obtenir un système sec au toucher après traitement.

Pour cela, on dispose le système enduit de silicone après réticulation sur une surface plane et rigide, la silicone étant sur la face supérieure. On fait une trace avec le doigt puis on examine à l'oeil la trace ainsi faite, de préférence en lumière rasante. La présence d'une trace au doigt est révélateur d'un défaut de réticulation.

Les doses minimales à appliquer pour obtenir un revêtement ou support bien réticulé, c'est-à-dire ne présentant pas de trace, sont données dans le tableau 4. Une composition témoin T0 ne contenant pas d'amorceur a été évaluée pour vérifier que le silicone époxy ne réticulait pas sous faisceau d'électrons sans amorceur.

**Tableau 4**

| Composition | Dose minimale (kGy) | Intensité I (mA) |
|---|---|---|
| T0 | >80 | 3 |
| C1 | 30 | 3 |
| C2 | < 1 | 0,3 |
| C3 | 20 | 3 |
| C5 | 30 | 3 |
| C6 | 30 | 3 |
| C7 | 5 | 1 |
| C8 | <1 | 0,3 |

Les amorceurs A1, A2, A3 et A4 de l'invention, bien qu'utilisés à des concentrations plus faibles que les amorceurs connus T1, T2 et T3, présentent une réactivité beaucoup plus élevée que ces derniers.

### A5 - Evaluation de la force de pelage.

Dans ces tests utilisés dans le cadre de l'anti-adhérence papier, on évalue la force de pelage nécessaire pour décoller un support frontal adhésivé appliqué sur un support siliconé réticulé obtenu à partir de chaque composition.

### a) Adhésivation.

L'adhésivation des revêtements ou supports siliconés réticulés obtenus après traitement par faisceau d'électrons est effectuée 15 minutes après l'irradiation avec les deux rubans adhésifs. Les deux rubans adhésifs de test type utilisés sont le TESA 4970 commercialisé par la société Beiersdorf ou le RHODOTAK 338 J commercialisé par la société RHODIA.

Les complexes adhésivés ainsi réalisés sont conservés sous une pression de 70 g/cm² (correspondant à la pression exercée dans une bobine en sortie de machine) sous une hygromètrie de 53-54 % à différentes températures.

### b) Vieillissement.

Ensuite, on effectue pour chaque complexe adhésivé, deux types de vieillissement accéléré en température :
- 20 h à 70°C selon la méthode FINAT 10
- 7 jours à 70°C.

On effectue ces vieillissements accélérés pour simuler l'évolution du complexe adhésivé au cours de stockage naturel. La stabilité des forces de pelage au cours du temps est une propriété primordiale dans le cadre de l'application anti-adhérence papier.

### c) Mesure des forces de pelage.

Cette force s'exprime en g/cm et est mesurée à l'aide d'un dynamomètre Instron 4301 possédant les spécifications suivantes :
- traction de 0,5 à 5 kN.
- vitesse de traverse de 0,5 à 500 mm/mn.

Les forces de pelage sont mesurées avec un angle entre le support siliconé et l'adhésif de 180° et à la vitesse de 0,3 m/mn.
Les compositions décrites précédemment ont été réticulées à diverses doses d'irradiation. Les résultats obtenus dans les essais 1 à 16 sont décrits dans les tableaux 4 et 5.

Selon les données des 2 tableaux 5 et 6, il apparaît clairement que l'utilisation des amorceurs A1, A2, A3 et A4, selon l'invention permet d'obtenir des revêtements bien réticulés dans des conditions économiques avantageuses puisque l'énergie nécessaire pour fabriquer ces revêtements est beaucoup plus faible, comparée à celle nécessaire pour les amorceurs cités à titre comparatif.

La stabilité des forces de pelage lors des vieillissements accélérés est meilleure avec les amorceurs de l'invention, en particulier avec l'amorceur A3, qui conduit à des résultats excellents, bien que la concentration en amorceur utilisée soit deux fois plus faible que dans les exemples E1, E2, E3, E4, E7 ou E8.

On note également que différents niveaux de forces de pelage sont atteints en faisant varier la nature de l'amorceur et la dose appliquée, sans que la stabilité des forces de pelage dans ces cas ne soit altérée.

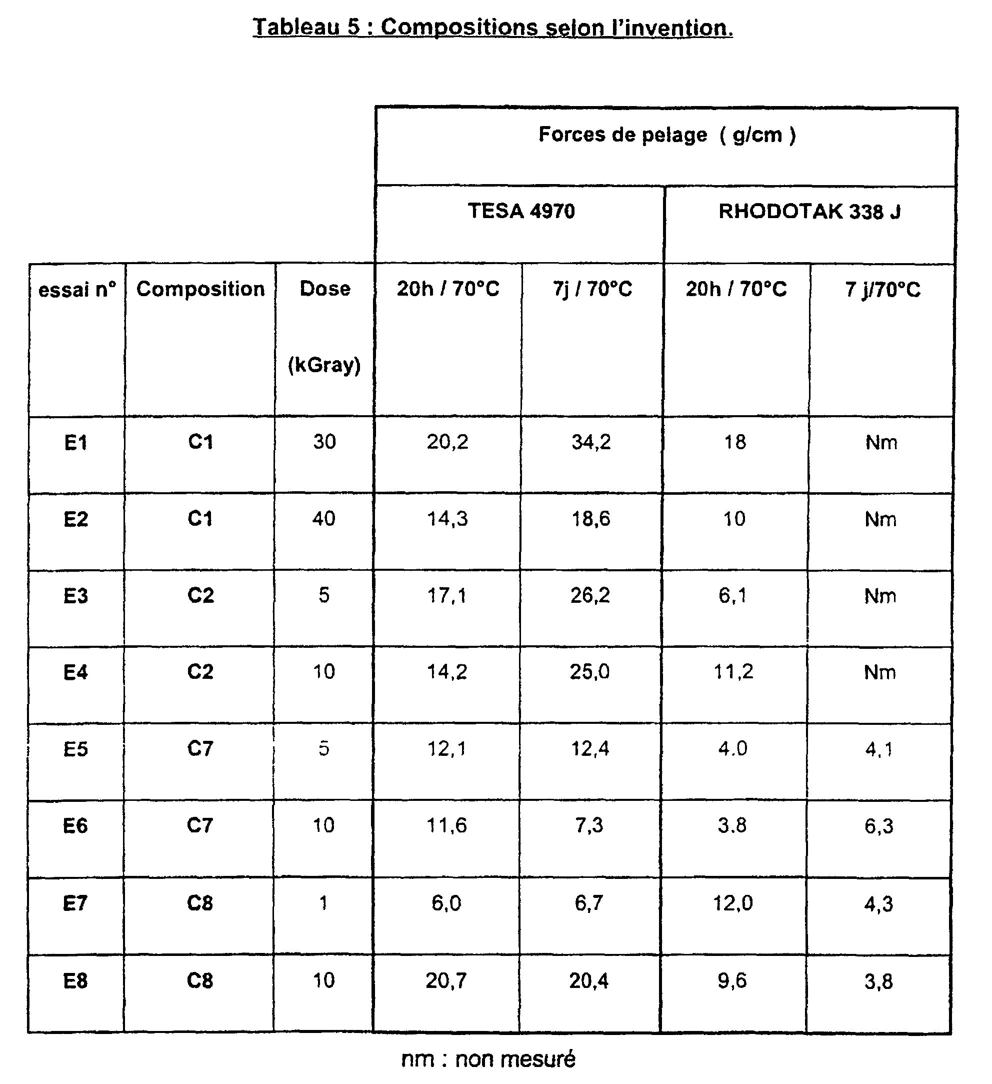

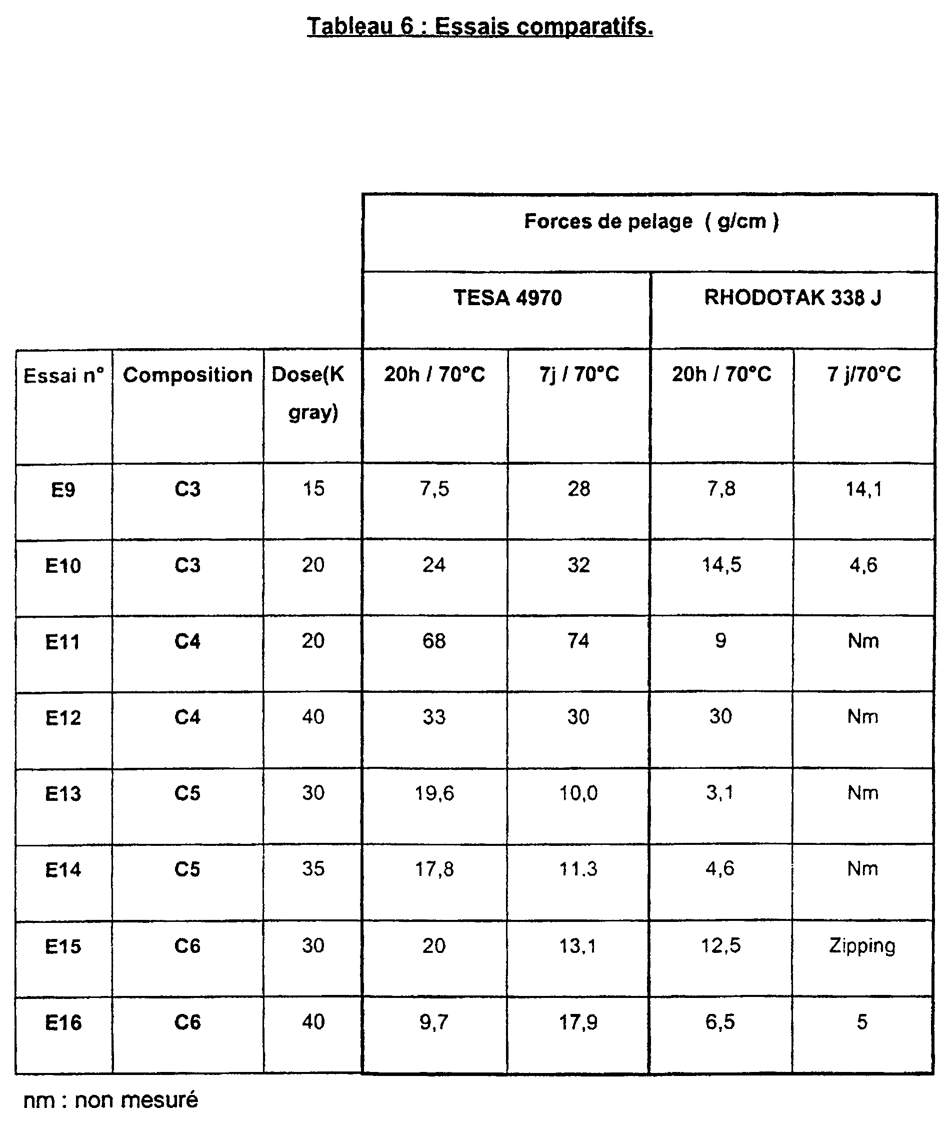

### B1 - Préparation des formulations à enduire.

Les amorceurs utilisés sont A2 et T1.

Chaque amorceur est mis en solution avec de l'isopropanol. Puis, cette solution est ajoutée au silicone epoxy (IV). Les mélanges amorceur-solvant et les formulations avec le silicone epoxy sont donnés ci-dessous respectivement dans le tableau 7. Les compositions obtenues sont limpides. Pour la composition A2, le % d'amorceur en poids dans le solvant est de 11,8 et pour la composition T1, le % d'amorceur en poids dans le solvant est de 16,7.

**Tableau 7**

| Composition | Amorceur | Masse solution amorceur (g) | Masse de islicone époxy (g) | Concentration en Amorceur pour 100 g de silicone époxy x10⁻⁴ moles |
|---|---|---|---|---|
| C9 | A2 | 1,2 | 100 | 1,97 |
| C10 | T1 | 1,2 | 100 | 1,97 |

### B2 - Enduction.

Chaque composition est enduite sur du papier Glassine (Ahlstrom, référence Silcote 2010) à l'aide de cylindre lisse enducteur.

Le papier Glassine est stocké en rouleau sur une machine industrielle. La vitesse mécanique de défilement de la bande de papier peut être variée et est comprise entre 10 et 1000 m/min.

Le papier Glassine est enduit de la composition à l'aide d'un cylindre lisse. La quantité est indiquée dans le tableau pour chaque essai (E17 à E28).

### B3 - Traitement du papier enduit, sous faisceau d'électrons.

La surface de papier enduite est ensuite irradiée sous un faisceau d'électrons généré sous une tension d'excitation de 150 kilovolts. La dose D pour chaque test est donnée dans le tableau 8.
- D =: k(I/V) en kgray.
- k =: facteur lié à l'unité.
- V =: vitesse de défilement.
- I =: intensité du courant.

### B4 - Evaluation de la réticulation par le test au toucher.

La réticulation pour chaque essai est évaluée. Pour cela, on dispose le papier Glassine enduit de la composition silicone réticulée sur une surface plane et rigide, la composition silicone étant sur la face supérieure.

On fait une trace avec le doigt puis on examine à l'oeil la trace ainsi faite, de préférence en lumière rasante. La présence d'une trace au doigt est révélateur d'un défaut de réticulation. Les résultats sont donnés tableau 8.

### B5 - Evaluation de la force de pelage.

La force de pelage nécessaire pour décoller un support frontal adhésivé appliqué sur le papier Glassine enduit de la composition silicone réticulée obtenue à partir de chaque composition C9 et C10 est évaluée.

### a) Adhésivation.

L'adhésivation des papiers siliconés réticulés obtenus après traitement par faisceau d'électrons est effectuée 15 minutes après l'irradiation avec les deux rubans adhésifs. Le ruban adhésif de test type utilisé est le ruban TESA 4970 de la société Beiersdorf.

Les complexes adhésivés ainsi réalisés sont conservés sous une pression de 70 g/cm² (correspondant à la pression exercée dans une bobine en sortie de machine) sous une hygromètrie de 53-54 % à différentes températures..

### b) Vieillissement.

Ensuite, on effectue pour chaque complexe adhésivé, différents types de tests de vieillissement :
(i) 20 h à 20°C selon la méthode FINAT 3.
(ii) 20 h à 70°C selon la méthode FINAT 10. (iii) 7 jours à 70°C.
(iv) 1 mois.
(v) 3mois.

On effectue les vieillissements accélérés (i) à (iii) pour simuler l'évolution du complexe adhésivé au cours de stockage naturel. La stabilité des forces de pelage au cours du temps est une propriété primordiale dans le cadre de l'application anti-adhérence papier.
Les résultats des tests de vieillissement sont donnés tableau 8.

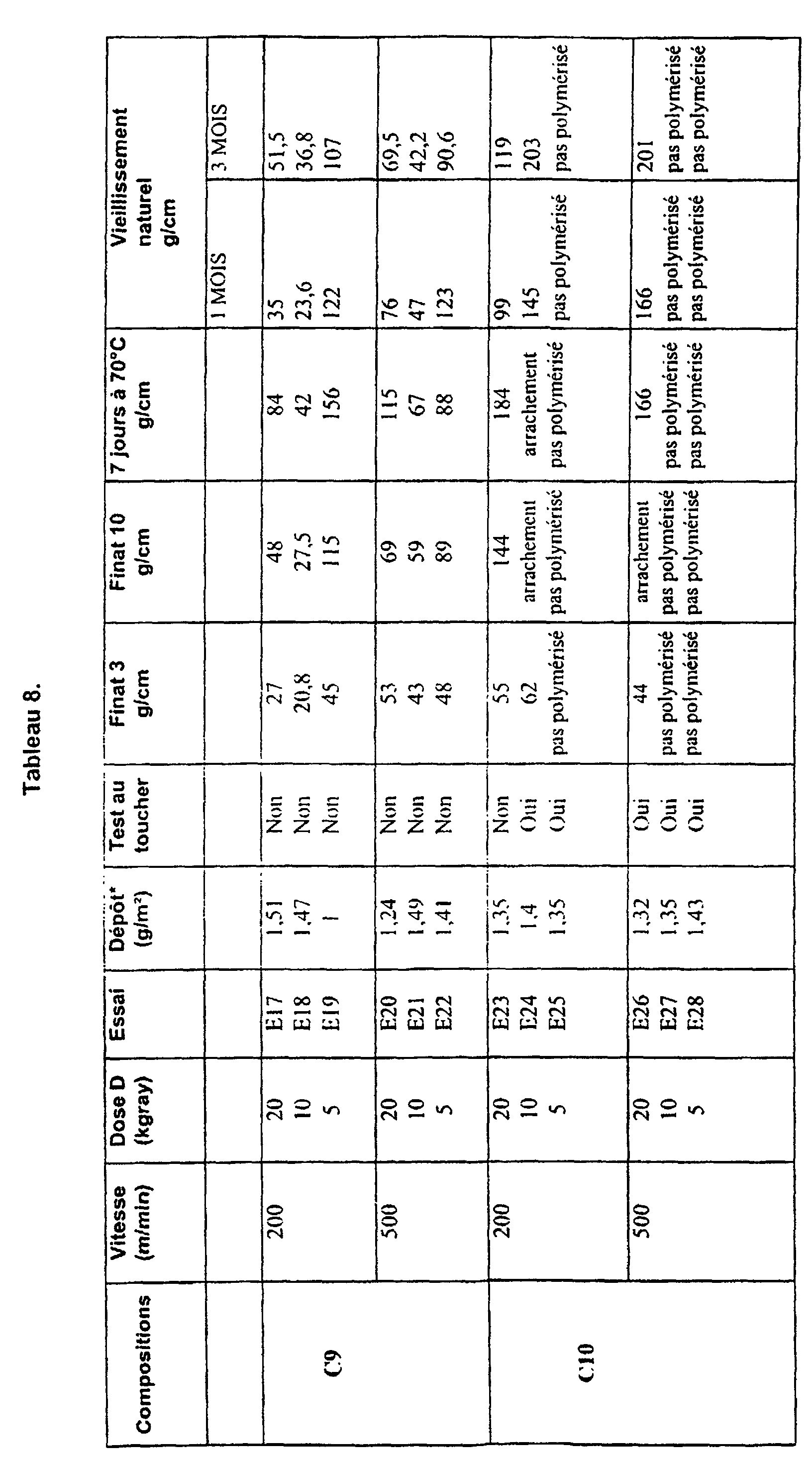

## Revendications

1. Procédé de réticulation et/ou polymérisation sous faisceau d'électrons et/ou rayons gamma, de compositions à base de monomères et/ou de polymères à groupements organofonctionnels **caractérisé en ce que** la réticulation et/ou polymérisation s'effectue en présence d'un amorceur activable sous faisceau d'électrons et/ou rayon gamma comprenant un dérivé du bore de formule M⁺B(Ar)₄⁻. (I) dans laquelle :
- M⁺, entité portant une charge positive, est un métal alcalin choisi parmi ceux des colonnes IA et IIA de la classification périodique (CAS version),
- Ar est un dérivé aromatique, éventuellement substitué par au moins un substituant choisi parmi un radical fluor, un radical chlore, une chaîne alkyle linéaire ou ramifiée, elle-même pouvant être substituée par au moins un groupement électroattracteur tel que CₙF₂ₙ₊₁ avec n étant compris entre 1 et 18, F, et OCF₃.

2. Procédé selon la revendication **1 caractérisé en ce que** M, métal alcalin, est choisi parmi le lithium, le sodium, le césium et/ou le potassium.

3. Procédé selon la revendication **1 caractérisé en ce que** le dérivé du bore est choisi parmi LiB(C₆F₅)₄, KB(C₆F₅)₄, KB(C₆H₃(CF₃)₂)₄ et CsB(C₆F₅).

4. Procédé selon l'une quelconque des revendications précédentes, **caractérisé en ce que** les monomères, oligomères et/ou polymères sont de nature organique et/ou de nature polyorganosiloxanique ; les groupements organofonctionnels étant des groupements époxydes, oxétannes, alkényléthers et/ou acryliques.

5. Procédé selon la revendication **4**, **caractérisé en ce que** les monomères, oligomères et polymères à groupements organofonctionnels sont de nature polyorganosiloxanique, et constitués de motifs de formule (IV) et terminés par des motifs de formule (V) ou cycliques constitués de motifs de formule (IV) représentées ci-dessous : 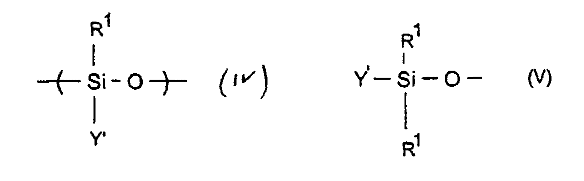 dans lesquelles :
- les symboles **R**^{**1**} sont semblables ou différents et représentent :
· un radical alkyle linéaire ou ramifié contenant 1 à 8 atomes de carbone, éventuellement substitué par au moins un halogène, de préférence le fluor, les radicaux alkyle étant de préférence méthyle, éthyle, propyle, octyle et 3,3,3-trifluoropropyle,
· un radical cycloalkyle contenant entre 5 et 8 atomes de carbone cycliques, éventuellement substitué,
· un radical aryle contenant entre 6 et 12 atomes de carbone pouvant être substitué, de préférence phényle ou dichlorophényle,
· une partie aralkyle ayant une partie alkyle contenant entre 5 et 14 atomes de carbone et une partie aryle contenant entre 6 et 12 atomes de carbone, substituée éventuellement sur la partie aryle par des halogènes, des alkyles et/ou des alkoxyles contenant 1 à 3 atomes de carbone,
- les symboles **Y'** sont semblables ou différents et représentent :
· le groupement **R**^{**1**},
· un radical hydrogène,
· et/ou un groupement organofonctionnel réticulable, de préférence un groupement époxyfonctionnel et/ou vinyloxyfonctionnel, relié au silicium du polyorganosiloxane par l'intermédiaire d'un radical divalent contenant de 2 à 20 atomes de carbone et pouvant contenir au moins un hétéroatome, de préférence de l'oxygène,
· et l'un au moins des symboles **Y'** représentant un groupement organique fonctionnel réticulable.

6. Procédé selon la revendication 5, **caractérisé en ce qu'**au moins un des symboles **R**^{**1**} des polyorganosiloxanes utilisés représente un radical phényle, tolyle ou dichlorophényle.

7. Procédé selon l'une quelconque des revendications **4** à **6, caractérisé en ce que** la composition réticulable comprend de plus, des monomères, oligomères et/ou polymères à groupements organofonctionnels d'espèce acrylate ; et notamment acrylates époxydés, acrylo-glycéro-polyesters, acrylates multifonctionneis, acrylo-uréthanes, acrylo-polyéthers, acrylo-polyesters, polyesters insaturés, acrylo-acryliques,

8. Composition polymérisable et/ou réticulable sous faisceau d'électrons et/ou rayons gamma **caractérisée en ce que** la composition comprend au moins une matrice à base de monomère(s), oligomère(s) et/ou polymère(s) de nature polyorganosiloxanique à groupements organofonctionnels polymérisables et/ou réticulables, et au moins un amorceur activable sous faisceau d'électrons et/ou rayons gamma comprenant un dérivé du bore de formule M⁺B(Ar)₄⁻ (I) dans laquelle:
- M⁺, entité portant une charge positive, est un métal alcalin choisi parmi ceux des colonnes IA et IIA de la classification périodique (CAS version),
- Ar est un dérivé aromatique, éventuellement substitué par au moins un substituant choisi parmi un radical fluor, un radical chlore, une chaîne alkyle linéaire ou ramifiée, elle-même pouvant être substituée par au moins un groupement électroattracteur tel que CₙF₂ₙ₊₁ avec n étant compris entre 1 et 18, F, et OCF₃.

9. Composition selon la revendication **8 caractérisée** en que les monomères, oligomères et/ou polymères de la matrice sont choisis parmi ceux de la revendication 5.

10. Résine susceptible d'être obtenue à partir du procédé selon l'une quelconque des revendications **1** à **7** ou à partir d'une composition selon l'une quelconque des revendications **8** ou **9.**

11. Revêtement à base de résine selon la revendication **10.**

12. Revêtement selon la revendication **11, caractérisé en ce que** le revêtement est un vernis, un revêtement adhésif, un revêtement anti-adhérent et/ou une encre.

13. Matériau composite à base de résine selon la revendication **10.**

14. Objet dont une surface au moins est revêtue de résine selon la revendication **10** ou d'un matériau composite selon la revendication **13.**

15. Utilisation de résine selon la revendication **10** pour la fabrication de revêtements ou de matériaux composites.

## Patentansprüche

1. Verfahren zur Vernetzung und/oder Polymerisation durch Elektronenstrahlen und/oder Gamma-Strahlung von Zusammensetzungen auf der Basis von Monomeren und/oder Polymeren mit organofunktionellen Gruppen, **dadurch gekennzeichnet, dass** die Vernetzung und/oder Polymerisation in Gegenwart eines Initiators erfolgt, der durch Elektronenstrahlen und/oder Gamma-Strahlung aktivierbar ist, umfassend ein Borderivat der Formel M⁺B(Ar)₄⁻ (I), worin:
- M⁺, eine Einheit, die eine positive Ladung trägt, ein Alkalimetall ist, das ausgewählt ist unter denjenigen der Gruppen IA und IIA des Periodensystems (CAS-Version),
- Ar ein aromatisches Derivat ist, gegebenenfalls mit wenigstens einem Substituenten substituiert, der ausgewählt ist unter einem Fluorrest, einem Chlorrest, einer linearen oder verzweigten Alkylkette, die selbst mit wenigstens einer elektronenanziehenden Gruppe, wie CₙF₂ₙ₊₁, wobei n zwischen 1 und 18 liegt, F und OCF₃, substituiert sein kann.

2. Verfahren gemäß Anspruch 1, **dadurch gekennzeichnet, dass** das Alkalimetall M unter Lithium, Natrium, Cäsium und/oder Kalium ausgewählt ist.

3. Verfahren gemäß Anspruch 1, **dadurch gekennzeichnet, dass** das Borderivat unter LiB(C₆F₅)₄, KB(C₆F₅)₄, KB(C₆H₃(CF₃)₂)₄ und CsB(C₆F₅) ausgewählt ist.

4. Verfahren gemäß einem der vorhergehenden Ansprüche, **dadurch gekennzeichnet. dass** die Monomere, Oligomere und/oder Polymere organischer Art und/oder der Art Polyorganosiloxan sind; wobei die organofunktionellen Gruppen Epoxid-, Oxetan-, Alkenylether- und/oder Acrylgruppen sind.

5. Verfahren gemäß Anspruch 4, **dadurch gekennzeichnet, dass** die Monomere, Oligomere und Polymere mit organofunktionellen Gruppen der Art Polyorganosiloxan sind und gebildet werden aus Einheiten der Formel (IV), die mit Einheiten der Formel (V) abschließen, oder cyclischen Einheiten, die aus Einheiten der Formel (IV) bestehen, im Folgenden dargestellt: 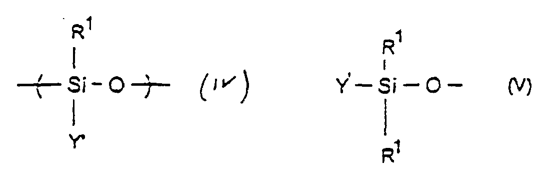 worin
- die Symbole R¹ ähnlich oder verschieden sind und darstellen:
· einen linearen oder verzweigten Alkylrest mit 1 bis 8 Kohlenstoffatomen, gegebenenfalls substituiert mit wenigstens einem Halogen, vorzugsweise Fluor, wobei die Alkylreste vorzugsweise Methyl, Ethyl, Propyl, Octyl und 3,3,3-Trifluorpropyl sind,
· einen Cycloalkylrest mit 5 bis 8 cyclischen Kohlenstoffatomen, gegebenenfalls substituiert,
· einen Arylrest mit 6 bis 12 Kohlenstoffatomen, der substituiert sein kann, vorzugsweise Phenyl oder Dichlorphenyl,
· einen Aralkylteil, der einen Alkylteil mit 5 bis 14 Kohlenstoffatomen und einen Arylteil mit 6 bis 12 Kohlenstoffatomen hat, gegebenenfalls am Arylteil substituiert mit Halogenen, Alkylen und/oder Alkoxylen mit 1 bis 3 Kohlenstoffatomen,
- die Symbole Y' ähnlich oder verschieden sind und darstellen:
· die Gruppe R¹,
· einen Wasserstoffrest,
· und/oder eine vernetzbare organofunktionelle Gruppe, vorzugsweise eine epoxyfunktionelle und/oder vinyloxyfunktionelle Gruppe, gebunden an das Silicium des Polyorganosiloxans über einen zweiwertigen Rest mit 2 bis 20 Kohlenstoffatomen, der wenigstens ein Heteroatom, vorzugsweise Sauerstoff, enthalten kann,
· und wobei wenigstens eines der Symbole Y' eine vemetzbare funktionelle organische Gruppe darstellt.

6. Verfahren gemäß Anspruch 5, **dadurch gekennzeichnet, dass** wenigstens eines der Symbole R¹ der verwendeten Polyorganosiloxane einen Phenyl-, Tolyl- oder Dichlorphenylrest darstellt.

7. Verfahren gemäß einem der Ansprüche 4 bis 6, **dadurch gekennzeichnet, dass** die vernetzbare Zusammensetzung außerdem Monomere, Oligomere und/oder Polymere mit organofunktionellen Gruppen der Spezies Acrylat umfasst; und insbesondere Epoxyacrylate, Polyacrylglycerinester, multifunktionelle Acrylate, Acrylurethane, Polyacrylether, Polyacrylester, ungesättigte Polyacryloacrylester.

8. Durch Elektronenstrahlen und/oder Gamma-Strahlung polymerisierbare und/oder vernetzbare Zusammensetzung, **dadurch gekennzeichnet, dass** die Zusammensetzung enthält wenigstens eine Matrix auf der Basis von Monomer(en), Oligomer(en) und/oder Polymer(en) der Art Polyorganosiloxan mit polymerisierbaren und/oder vernetzbaren organofunktionellen Gruppen und wenigstens einen durch Elektronenstrahlen und/oder Gamma-Strahlung aktivierbaren Initiator, umfassend ein Borderivat der Formel M⁺B(Ar)₄⁻ (I), worin:
- M⁺, eine Einheit, die eine positive Ladung trägt, ein Alkalimetall ist, das ausgewählt ist unter denjenigen der Gruppen IA und IIA des Periodensystems (CAS-Version),
- Ar ein aromatisches Derivat ist, gegebenenfalls mit wenigstens einem Substituenten substituiert, der ausgewählt ist unter einem Fluorrest, einem Chlorrest, einer linearen oder verzweigten Alkylkette, die selbst mit wenigstens einer elektronenanziehenden Gruppe, wie CₙF₂ₙ₊₁, wobei n zwischen 1 und 18 liegt, F und OCF₃, substituiert sein kann.

9. Zusammensetzung gemäß Anspruch 8, **dadurch gekennzeichnet, dass** die Monomere, Oligomere und/oder Polymere der Matrix unter denjenigen des Anspruchs 5 ausgewählt sind.

10. Harz, das aus dem Verfahren gemäß einem der Ansprüche 1 bis 7 oder aus einer Zusammensetzung gemäß einem der Ansprüche 8 oder 9 erhalten werden kann.

11. Beschichtung auf der Basis von Harz gemäß Anspruch 10.

12. Beschichtung gemäß Anspruch 11, **dadurch gekennzeichnet, dass** die Beschichtung ein Lack, eine Klebebeschichtung, eine Antihaftbeschichtung und/oder eine Druckfarbe ist.

13. Compositmaterial auf der Basis von Harz gemäß Anspruch 10.

14. Gegenstand, bei dem wenigstens eine Oberfläche mit Harz gemäß Anspruch 10 oder einem Compositmaterial gemäß Anspruch 13 beschichtet ist.

15. Verwendung von Harz gemäß Anspruch 10 für die Herstellung von Beschichtungen oder Compositmaterialien.

## Claims

1. Process for crosslinking and/or polymerizing, under an electron beam and/or gamma radiation, compositions based on monomers and/or on polymers with organofunctional groups, **characterized in that** the crosslinking and/or polymerization is carried out in the presence of an initiator which can be activated under an electron beam and/or gamma radiation comprising a boron derivative of formula M⁺B(Ar)₄⁻ (I), in which:
- M⁺, an entity carrying a positive charge, is an alkali metal chosen from those from columns IA and IIA of the Periodic Classification (CAS version),
- Ar is an aromatic derivative, optionally substituted by at least one substituent chosen from a fluorine radical, a chlorine radical or a linear or branched alkyl chain, which can itself be substituted by at least one electron-withdrawing group, such as CₙF₂ₙ₊₁, with n being between 1 and 18, F and OCF₃.

2. Process according to claim 1, **characterized in that** M, an alkali metal, is chosen from lithium, sodium, caesium and/or potassium.

3. Process according to claim 1, **characterized in that** the boron derivative is chosen from LiB(C₆F₅)₄, KB(C₆F₅)₄, KB(C₆H₃(CF₃)₂)₄ and CsB(C₆F₅).

4. Process according to any one of the preceding claims, **characterized in that** the monomers, oligomers and/or polymers are of organic nature and/or of polyorganosiloxane nature, the organofunctional groups being epoxide, oxetane, alkenyl ether and/or acrylic groups.

5. Process according to claim 4, **characterized in that** the monomers, oligomers and polymers with organofunctional groups are of polyorganosiloxane nature and are composed of units of formula (IV) and are terminated by units of formula (V) or are cyclic and are composed of units of formula (IV) represented below: 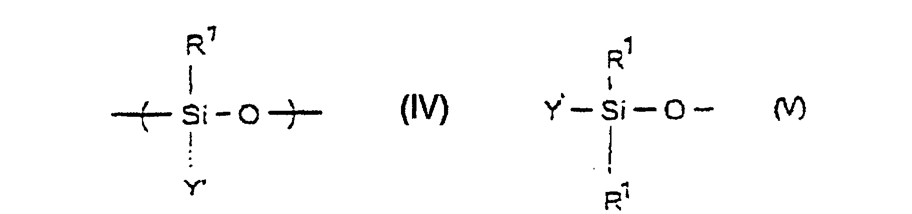 in which:
- the R¹ symbols are alike or different and represent:
- a linear or branched alkyl radical comprising 1 to 8 carbon atoms which is optionally substituted by at least one halogen, preferably fluorine, the alkyl radicals preferably being methyl, ethyl, propyl, octyl and 3,3,3-trifluoropropyl,
- an optionally substituted cycloalkyl radical comprising between 5 and 8 cyclic carbon atoms,
- an aryl radical comprising between 6 and 12 carbon atoms which can be substituted, preferably phenyl or dichlorophenyl,
- an aralkyl part having an alkyl part comprising between 5 and 14 carbon atoms and an aryl part comprising between 6 and 12 carbon atoms, which is optionally substituted on the aryl part by halogens, alkyls and/or alkoxyls comprising 1 to 3 carbon atoms,
- the Y' symbols are alike or different and represent:
- the R¹ group,
- a hydrogen radical,
- and/or a crosslinkable organofunctional group, preferably an epoxyfunctional and/or vinyloxyfunctional group, connected to the silicon of the polyorganosiloxane via a divalent radical comprising from 2 to 20 carbon atoms which can comprise at least one heteroatom, preferably oxygen,
- and at least one of the Y' symbols representing a crosslinkable functional organic group.

6. Process according to claim 5, **characterized in that** at least one of the R¹ symbols of the polyorganosiloxanes used represents a phenyl, tolyl or dichlorophenyl radical.

7. Process according to any one of claims 4 to 6, **characterized in that** the crosslinkable composition additionally comprises monomers, oligomers and/or polymers comprising organofunctional groups of acrylate kind and in particular epoxidized acrylates, polyester glycerol acrylates, multifunctional acrylates, urethane acrylates, polyether acrylates, polyester acrylates, unsaturated polyesters or acrylic acrylates.

8. Composition which can be polymerized and/or crosslinked under an electron beam and/or gamma radiation, **characterized in that** the composition comprises at least one matrix based on monomer(s), oligomer(s) and/or polymer(s) of polyorganosiloxane nature with polymerizable and/or crosslinkable organofunctional groups and at least one initiator which can be activated under an electron beam and/or gamma radiation comprising a boron derivative of formula M⁺B(Ar)₄⁻ (I), in which:
- M⁺, an entity carrying a positive charge, is an alkali metal chosen from those from columns IA and IIA of the Periodic Classification (CAS version),
- Ar is an aromatic derivative, optionally substituted by at least one substituent chosen from a fluorine radical, a chlorine radical or a linear or branched alkyl chain, which can itself be substituted by at least one electron-withdrawing group, such as CₙF₂ₙ₊₁, with n being between 1 and 18, F and OCF₃.

9. Composition according to claim 8, **characterized in that** the monomers, oligomers and/or polymers of the matrix are chosen from those of claim 5.

10. Resin which can be obtained from the process according to any one of claims 1 to 7 or from a composition according to either one of claims 8 and 9.

11. Coating based on a resin according to Claim 10.

12. Coating according to claim 11, **characterized in that** the coating is a varnish, an adhesive coating, a nonstick coating and/or an ink.

13. Composite material based on a resin according to claim 10.

14. Item, at least one surface of which is coated with a resin according to claim 10 or with a composite material according to claim 13.

15. Use of a resin according to claim 10 for the manufacture of coatings or composite materials.
